# EUROPEAN PATENT SPECIFICATION

(11) **EP 1 524 410 B1**
(45) Date of publication and mention of the grant of the patent: **25.10.2006**
(21) Application number: 05000235.1
(22) Date of filing: 26.02.1999
(51) Int. Cl.: F01D 5/30, F01D 5/28

(54) **Gas turbine rotor stage and rotor blade with coated rotor blade root and method for coating such a rotor blade root**
Gasturbinenrotorstufe und -rotorschaufel mit beschichtetem Rotorschaufelfuss und Beschichtungsverfahren für einen solchen Rotorschaufelfuss
Etage et aube de rotor de turbine à gaz ayant un pied d'aube de rotor pourvu d'un revêtement et procédé de revêtement d'un tel pied d'aube de rotor

(30) Priority: 26.02.1998 US 31498
(43) Date of publication of application: 20.04.2005
(62) Divisional of application: 99301443.0
(73) Proprietor: UNITED TECHNOLOGIES CORPORATION, Hartford, CT 06101 (US)
(72) Inventor: Hollis, Terry L., Lantana, Florida 3346202562 (US); Rising, Thomas J., Palm City, Florida 34990 (US); Dorrance, John G., Jupiter, Florida 33458 (US); Beeman, Bruce I. Jr., West Palm Beach, Florida 33412 (US)
(74) Representative: Leckey, David Herbert

(56) References cited:
- US-A- 5 160 243
- US-A- 5 240 375

## Description

This invention relates to gas turbine engine rotor assemblies in general, and to apparatus for inhibiting frictional wear between mating titanium alloy substrates such as a rotor blade root and rotor disk slot, in particular.

A conventional rotor stage of a gas turbine engine includes a disk and a plurality of rotor blades. The disk includes an inner hub, an outer hub and a web extending between the two hubs. The outer hub includes a plurality of blade attachment slots uniformly spaced around the circumference of the outer hub. Each rotor blade includes an airfoil and a blade root. The blade root of each blade is received within one of the blade attachment slots disposed within the disk. A variety of attachment slot / blade root mating pair geometries (e.g., dovetail, fir-tree) can be used.

Gas turbine rotor stages rotate at high velocities through high temperature gas traveling axially through the engine. The high temperature, high velocity environment places a great deal of stress on each blade root / attachment slot pair. For example, centrifugal force acting on each blade will cause the blade root to travel radially within the attachment slot as a load is applied and removed. In a similar manner, vibratory loadings can cause relative movement between blade root and attachment slot. In both cases, the relative motion between blade root and attachment slot is resisted by the mating geometry and by friction. The friction, in turn, causes undesirable frictional wear unless appropriate measures are taken.

The undesirable frictional wear referred to above predominantly consists of a "galling" process and/or a "fretting" process. Metals used in the manufacture of gas turbine rotor assemblies such as titanium, nickel, and others form a surface oxide layer almost immediately upon exposure to air. The oxide layer inhibits bonding between like or similar metals that are otherwise inclined to bond when placed in contact with one another. Galling occurs when two pieces of metal, for example a titanium alloy blade root and a titanium alloy blade attachment slot, frictionally contact one another and locally disrupt the surface oxide layer. In the brief moment between the disruption of the surface oxide layer and the formation of a new surface oxide layer on the exposed substrate, metal from one substrate can transfer to the other substrate and be welded thereto. The surface topography consequently changes further aggravating the undesirable frictional wear. Fretting occurs when the frictional contact between the two substrates disrupts the surface oxide layer and the exposed metal begins to corrode rather than exchange metal as is the case with galling.

In some applications, galling can be substantially avoided by positioning a dissimilar, softer metal between the two wear surfaces. The softer metal, and oxides formed thereon, provide a lubricious member between the two wear surfaces. Simply inserting a softer metal between the wear surfaces does not, however, provide a solution for every application. On the contrary, the lubricious member must be tolerant of the application environment. In the high temperature, high load environment of a gas turbine engine rotor, the choice of a lubricious medium is of paramount importance. The lubricious member must: 1) minimize galling and fretting between titanium and titanium alloys substrates; 2) tolerate high temperatures; and 3) accommodate high loads.

U. S. Patent No. 4,196,237 issued to Patel et al. (hereinafter referred to as Patel) reports that a disadvantage of an aluminium bronze (Al-Bronze) coating as an anti-gallant is that such a coating has a relatively low hardness. Patel further reports that a spray powder alloy which includes minor percentages of Ni, Fe, Al, and a majority percentage of Cu avoids the complained of hardness problem. In fact, Patel reports test results which include an evaluation of a 88% Cu-10% Al-2% Fe alloy sprayed onto a 1020 steel substrate (a metal not well suited for gas turbine rotor applications), as well as other similar alloys which include up to 10% Ni sprayed on the same steel substrate. Patel indicates that the sprayed alloys containing Ni showed a "marked improvement" in hardness and wear resistance relative to the alloy without the Ni when applied to a 1020 steel substrate.

U.S. Patent No. 4,215,181 issued to Betts (hereinafter referred to as Betts) discloses a method for inhibiting the effects of fretting fatigue in a pair of opposed titanium alloy mating surfaces. Betts indicates that copper shims provide beneficial protection from fretting when placed between the two opposed titanium alloy mating surfaces. Betts further indicates that a shim comprising an Al-Si-Bronze alloy did not prevent fretting fatigue of the substrates. In fact, Betts reports that the fatigue life of the specimen was essentially the same as that for the bare titanium fretting fatigue. A disadvantage of using a shim is that the shim, or a portion thereof, can dislodge and cause the then unprotected wear surfaces to contact one another. In a gas turbine engine application, dislodged shim (or portion thereof) can cause undesirable foreign object damage downstream. U.S. Patent No. 5,240,375, over which claims 1, 6 and 7 are characterised, and U.S. Patent No. 5,160,243 also disclose a shim disposed between a blade dovetail and a rotor disk dovetail slot.

Al-Bronze alloy anti-gallant coatings have been applied to nickel alloy stator van rails and feet to prevent galling between the stator vanes and iron alloy outer casings. The load stresses in the stator vane applications are of a different nature than those between a rotor blade root and a rotor disk slot. Specifically, the centrifugal loading on the rotor blade creates a much higher load, and are much more localized, than that between the stator vane and the outer casing. The rotor blade is also subject to a high cycle motion, and consequent high cycle friction.

What is needed, therefore, is a method and apparatus for inhibiting the effects of frictional wear in a rotor blade root / attachment slot pair, one capable of performing in a gas turbine engine environment, one that can be used with titanium alloy substrates, one that minimizes the opportunity for foreign object damage within a gas turbine engine, and one that is cost-effective.

According to an aspect of the present invention, there is provided a rotor blade for a gas turbine engine rotor stage as claimed in claim 1. In a preferred embodiment at least an air foil and blade root for use in a gas turbine engine are provided, the latter of which has an aluminium bronze alloy wear resistant coating. The coating consists essentially of 9 - 11% aluminium (Al), up to 1.5% iron (Fe), and a remainder of copper (Cu). The wear resistant coating is applied to a surface of the blade root and inhibits frictional wear between the blade root and a blade attachment slot.

According to another aspect of the present invention, there is provided a rotor stage for a gas turbine engine as claimed in claim 6.

According to another aspect of the present invention, a method for minimizing frictional wear between a rotor blade root and a rotor blade attachment slot as claimed is claim 7 is provided. The method comprises, in a preferred embodiment at least, providing an aluminium bronze alloy powder consisting essentially of 9 - 11% Al, up to 1.5% Fe, and a remainder of Cu; and applying the aluminium bronze alloy to a surface of said rotor blade root to form a coating thereon.

An advantage of the present invention is that a method and an apparatus for inhibiting the effects of frictional wear of a blade root is provided. In a preferred embodiment, the blade root and the root attachment slot comprise titanium alloy, which is one of a small number of alloys that can accommodate a gas turbine engine environment. A coating, such as that disclosed in the present invention, provides great utility by increasing the durability of titanium alloys in a gas turbine environment.

Another advantage of the present invention is that the effects of frictional wear between the blade root and the blade attachment slot is inhibited with minimal opportunity for foreign object damage. The present invention provides means for inhibiting wear between mating components without the use of shims which can dislodge and potentially create foreign object damage downstream within a gas turbine engine.

Another advantage of the present invention is that a coating is provided that can protect a titanium rotor blade root / attachment slot pair from galling. Centrifugal force acting on the rotor blade places a significant load on the rotor disk, and the rotor blade root is subject to high cycle motion relative to the rotor disk. Frictional energy dissipated by the high load, high cycle motion causes unacceptable deterioration in most anti-gallant coatings. The present invention coating provides an effective anti-gallant for rotor blade root / attachment slot applications within a gas turbine engine that withstands high load, high cycle motion applications.

A preferred embodiment of the present invention will now be described by way of example only and with reference to the accompanying drawings.

FIG. 1 is a diagrammatic partial view of a gas turbine engine rotor stage which includes a disk and a plurality of rotor blades conventionally attached to the disk.

FIG.2 is a graph which shows surface topography data generated in a test rig simulating a rotor blade root with a Cu-Ni anti-gallant coating interacting with a titanium test rig surface simulating a rotor blade attachment slot disposed in a rotor disk.

FIG.3 is a graph which shows surface topography data generated in a test rig simulating a rotor blade root with a Al-Bronze anti-gallant coating interacting with a titanium test rig surface simulating a rotor blade attachment slot disposed in a rotor disk.

In a gas turbine engine, each rotor stage 10 includes a plurality of rotor blades 12 and a rotor disk 14. The rotor disk 14 includes an outer hub 16, an inner hub (not shown), and a web 18 extending between the two hubs. A plurality of rotor blade attachment slots 20 are disposed in the outer hub 16, spaced around the circumference of the disk 14. Each rotor blade 12 includes an airfoil 22 and a blade root 24. The blade root 24 of each blade 12 is received within one of the blade attachment slots 20 disposed within the disk 14.

To minimize frictional wear, including galling and fretting, a lubricious wear resistant coating 26 is applied to the blade root 24 in a position such that the coating 26 is disposed between the blade root 24 and attachment slot when the blade root 24 is received within the attachment slot 20. For ease of application, the wear resistant coating 26 is applied to the blade root 24. The coating is formed from an Al-Bronze alloy powder comprising 9.0-11.0% Al, 0.0-1.50% Fe, balance Cu. The powder may, however, include up to 5% residual materials; i.e., materials which do not materially change the frictional properties of the coating. In the most preferred form, the powder consists essentially of 10% Al and 90% Cu.

The process of applying the coating begins by preparing the substrate surface (e.g., the blade root surface) to be coated. The first step is to remove debris and oxides from the substrate. Well known cleaning techniques such as degreasing, grit blasting, chemical cleaning, and/or electrochemical polishing can be used. For example, a degreasing solution followed by a grit blast procedure using #60 (200 microns) aluminum oxide grit applied with 35-45 p.s.i. (240-310 kPa) pressure is adequate. Using the described grit blast technique also provides a desirable surface finish.

The coating may be applied by a variety of processes including, but not limited to, plasma spray, physical vapor deposition, HVOF, and D-Gun. Of the processes tested, plasma spraying appeared to produce the most favorable results. The powder particulate size applied during the testing was in the range of 270 - 325 microns. The preferred particulate size will, however, vary depending on the application at hand (especially the surface finish of the mating substrate) and the desired coating roughness and microscopic properties of the application at hand. The powder was applied using a Plasmadyne^{™} plasma spray gun using argon as a primary gas and helium as a secondary gas. Application parameters such as primary and secondary gas flow rates, powder feed rate, will vary depending on the exact coating composition, the substrate composition, the application equipment, and the application environment. During testing the following application parameters were used:

| | |
|---|---|
| Primary Gas Volumetric Flow Rate: | 100-125 scfh (0.075-0.094 m³/s) |
| Secondary Gas Volumetric Flow Rate: | 25-40 scfh (0.018-0.030 m³/s) |
| Plasma Gun Voltage: | 35-50 volts DC |
| Plasma Gun Amperage: | 690-710 amps |
| Powder Feed Rate: | 25-35 grams/min |

The best test results were achieved when the coating was applied to a thickness between 0.0010 - 0.004 inches (25-100 microns). A coating thickness outside the aforementioned range may, however, be advantageous for some applications.

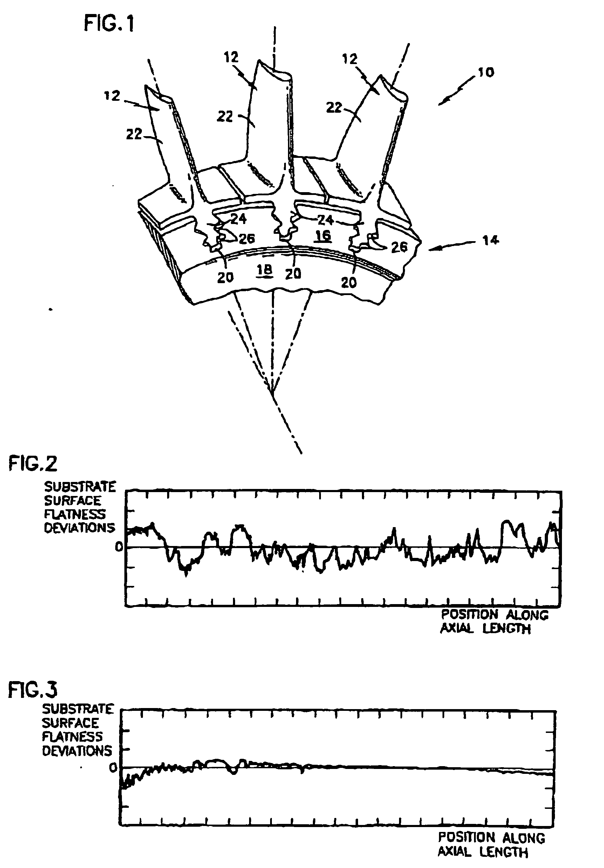

The graph shown in FIG.2 shows surface topography data (substrate surface flatness vs. substrate axial length) generated in a test rig simulating a rotor blade root with a Cu-Ni anti-gallant coating interacting with a titanium test rig surface simulating an attachment slot disposed in a rotor disk. The graph shown in FIG.3 shows a surface topography data (substrate surface flatness vs. substrate axial length) generated in a test rig simulating a rotor blade root with a Al-Bronze anti-gallant coating interacting with a titanium test rig surface simulating an attachment slot disposed in a rotor disk. The two tests were run under substantially the same test conditions. The surface graph depicting the Al-Bronze test data (FIG.3) illustrates significantly fewer surface flatness deviations occurred using the Al-Bronze coating than the Cu-Ni coating (depicted in FIG.2), thereby evidencing a much lower amount of undesirable frictional wear.

From the above, it will be seen that in its preferred embodiments at least, the invention provides a method and apparatus for inhibiting the effects of frictional wear between a blade root and attachment slot, a method and an apparatus for inhibiting the effects of frictional wear between a blade root and attachment slot comprising titanium alloy which is tolerant of a gas turbine engine environment, a method and an apparatus for inhibiting the effects of frictional wear which minimizes the opportunity for foreign object damage with a gas turbine engine, and a method and an apparatus for inhibiting the effects of frictional wear which is cost-effective.

While in the embodiment described, a coating is applied to just the surface of the blade root, it is possible within the scope of the invention to coat the surfaces of both the blade root and the blade attachment slot.

## Claims

1. A rotor blade (12) for a gas turbine engine rotor stage (10), comprising:
an airfoil (22); and
a blade root (24), attached to said airfoil (22); **characterised in that** the rotor blade further comprises:
an aluminum bronze alloy wear resistant coating applied to a surface of said blade root (24), said coating consisting essentially of 9.0-11.0% Al, 0.0-1.50% Fe, and a remainder of Cu.

2. A rotor blade (12) according to claim 1, wherein said aluminum bronze alloy coating comprises approximately 10.0% Al and a remainder of Cu.

3. A rotor blade (12) according to claim 1 or 2 wherein said aluminium bronze alloy coating includes up to 5% residual materials.

4. A rotor blade (12) according to claim 1, 2 or 3 wherein said aluminum bronze alloy coating has a thickness of between 0.0010 and 0.0040 inches (25 and 100 microns).

5. A rotor blade (12) according to any preceding claim, wherein said aluminum bronze alloy coating is applied by a plasma spray process.

6. A rotor stage (10) for a gas turbine engine rotor stage, comprising:
a titanium alloy rotor disk (14), having an outer hub (16) with a plurality of rotor blade attachment slots (20) disposed in said outer hub; the rotor stage further comprising:
a plurality of rotor blades (12) as claimed in any of claims 1 to 5 wherein each said blade root (24) is received within one of said rotor blade attachment slots (20) within said rotor disk (14); **characterized in that** a
wear resistant coating is applied to a said surface of each said blade root (24), such that said coating is disposed between said blade attachment slot (20) and said blade root (24) when said blade root (24) is received within said blade attachment slot (20).

7. A method for minimizing frictional wear between a rotor blade root (24) and a rotor blade attachment slot in a rotor disk (14), comprising
providing an aluminum bronze alloy powder consisting essentially of 9.0-11.0% Al, 0.0-1.50% Fe, and a remainder of Cu; **characterised in that** the method further comprises:
applying said aluminum bronze alloy powder to a surface of said rotor blade root (24), thereby forming a coating on said root (24).

8. A method according to claim 7, wherein said aluminum bronze alloy powder comprises approximately 10.0% Al and a remainder of Cu.

9. A method according to claim 7 or 8, wherein said aluminum bronze alloy powder is applied by a plasma spray process.

10. A method according to claim 7, 8 or 9, wherein said aluminum bronze alloy powder is applied until said coating has a thickness of between 0.0010 and 0.0040 inches (25 and 100 microns).

11. A method according to any of claims 7 to 10 wherein the rotor disk (14) comprises a titanium alloy.

## Patentansprüche

1. Rotorschaufel (12) für eine Gasturbinenmaschinen-Rotorstufe (10) aufweisend:
ein Strömungsprofil (22); und
eine Schaufelwurzel (24), die an dem Strömungsprofil (22) befestigt ist;
**dadurch gekennzeichnet, dass** die Rotorschaufel außerdem aufweist:
eine verschleißfeste, auf eine Oberfläche der Schaufelwurzel (24) aufgebrachte Aluminiumbronzelegierung-Beschichtung, wobei die Beschichtung im wesentlichen aus 9,0 bis 11,0 % Al, 0,0 bis 1,50 % Fe und einem Rest aus Cu besteht.

2. Rotorschaufel (12) nach Anspruch 1, bei der die Aluminiumbronzelegierung-Beschichtung näherungsweise 10,0 % Al und einen Rest aus Cu aufweist.

3. Rotorschaufel (12) nach Anspruch 1 oder 2, bei der die Aluminiumbronzelegierung-Beschichtung bis zu 5 % sonstige Materialien enthält.

4. Rotorschaufel (12) nach Anspruch 1, 2 oder 3, bei der die Aluminiumbronzelegierung-Beschichtung eine Dicke von zwischen 0,0010 und 0,0040 Inch (25 und 100 µm) hat.

5. Rotorschaufel (12) nach irgendeinem vorangehenden Anspruch, bei der die Aluminiumbronzelegierung-Beschichtung durch einen Plasmaspritzprozess aufgebracht ist.

6. Rotorstufe (10) für eine Gasturbinenmaschinen-Rotorstufe, aufweisend:
eine Titanlegierung-Rotorscheibe (14), die eine äußere Nabe (16) mit einer Mehrzahl an Rotorschaufel-Befestigungsschlitzen (20), die in der äußeren Nabe angebracht sind, besitzt;
wobei die Rotorstufe außerdem aufweist:
eine Mehrzahl an Rotorschaufeln (12) wie in irgendeinem der Ansprüche 1 bis 5 beansprucht, wobei jede Schaufelwurzel (24) in einem der Rotorschaufel-Befestigungsschlitze (20) in der Rotorscheibe (14) aufgenommen ist;
**dadurch gekennzeichnet, dass**
eine verschleißfeste Beschichtung auf eine Oberfläche jeder Schaufelwurzel (24) aufgebracht ist, so dass die Beschichtung zwischen dem Schaufel-Befestigungsschlitz (20) und der Schaufelwurzel (24) angebracht ist, wenn die Schaufelwurzel (24) in dem Schaufel-Befestigungsschlitz (20) aufgenommen ist.

7. Verfahren zum Minimieren des Reibungsverschleißes zwischen einer Rotorschaufelwurzel (24) und einem Rotorschaufel-Befestigungsschlitz in einer Rotorscheibe (14) aufweisend:
Bereitstellen eines Aluminiumbronzelegierung-Pulvers, das im wesentlichen aus 9,0 bis 11,0 % Al, 0,0 bis 1,50 % Fe, und einem Rest aus Cu besteht;
**dadurch gekennzeichnet, dass** das Verfahren außerdem aufweist:
Aufbringen des Aluminiumbronzelegierung-Pulvers auf eine Oberfläche der Rotorschaufelwurzel (24), wodurch eine Beschichtung auf der Wurzel (24) gebildet wird.

8. Verfahren nach Anspruch 7, bei dem das Aluminiumbronzelegierung-Pulver näherungsweise 10,0 % Al und einen Rest aus Cu aufweist.

9. Verfahren nach Anspruch 7 oder 8, bei dem das Aluminiumbronzelegierung-Pulver durch einen Plasmaspritzprozess aufgebracht wird.

10. Verfahren nach Anspruch 7, 8 oder 9, bei dem das Aluminiumbronzelegierung-Pulver aufgebracht wird bis die Beschichtung eine Dicke von zwischen 0,0010 und 0,0040 Inch (25 und 100 µm) hat.

11. Verfahren nach einem der Ansprüche 7 bis 10, bei dem die Rotorscheibe (14) eine Titanlegierung aufweist.

## Revendications

1. Aube de rotor (12) pour un étage de rotor de moteur à turbine à gaz (10), comprenant:
un profil aérodynamique (22) ; et
un pied d'aube (24), fixé audit profil aérodynamique (22) ;
**caractérisée en ce que** cette aube de rotor comprend en outre :
un revêtement résistant à l'usure en alliage de bronze d'aluminium appliqué sur une surface dudit pied d'aube (24), ledit revêtement consistant essentiellement de 9,0 à 11,0 % d'Al, 0,0 à 1,50 % de Fe, et le reste de Cu.

2. Aube de rotor (12) selon la revendication 1, dans laquelle ledit revêtement en alliage de bronze d'aluminium comprend approximativement 10,0 % d'Al et le reste de Cu.

3. Aube de rotor (12) selon la revendication 1 ou 2 dans laquelle ledit revêtement en alliage de bronze d'aluminium comprend jusqu'à 5 % de matériaux résiduels.

4. Aube de rotor (12) selon la revendication 1, 2 ou 3 dans laquelle ledit revêtement en alliage de bronze d'aluminium a une épaisseur entre 0,0010 et 0,0040 pouces (25 et 100 microns).

5. Aube de rotor (12) selon l'une quelconque des revendications précédentes, dans laquelle ledit revêtement en alliage de bronze d'aluminium est appliqué par un procédé de projection par plasma.

6. Étage de rotor (10) pour un étage de rotor de moteur de turbine à gaz, comprenant :
un disque de rotor en alliage de titane (14), ayant un moyeu externe (16) avec une pluralité de fentes de fixation d'aube de rotor (20) disposées dans ledit moyeu externe ; l'étage de rotor comprenant en outre :
une pluralité d'aubes de rotor (12) selon l'une quelconque des revendications 1 à 5 dans lequel chaque pied d'aube (24) est reçu à l'intérieur d'une desdites fentes de fixation d'aube de rotor (20) à l'intérieur dudit disque de rotor (14) ; **caractérisé en ce qu'**un revêtement résistant à l'usure est appliqué sur une desdites surfaces de chacun desdits pieds d'aube (24), de sorte que ledit revêtement est disposé entre ladite fente de fixation d'aube (20) et ledit pied d'aube (24) lorsque ledit pied d'aube (24) est reçu à l'intérieur de ladite fente de fixation d'aube (20).

7. Procédé pour minimiser l'usure de frottement entre un pied d'aube de rotor (24) et une fente de fixation d'aube de rotor dans un disque de rotor (14), comprenant :
la fourniture d'une poudre d'alliage de bronze d'aluminium consistant essentiellement de 9,0 à 11,0 % d'Al, 0,0 à 1,50 % de Fe, et le reste de Cu ; **caractérisé en ce que** le procédé comprend en outre :
l'application de ladite poudre d'alliage de bronze d'aluminium sur une surface dudit pied d'aube de rotor (24), formant de ce fait un revêtement sur ledit pied (24).

8. Procédé selon la revendication 7, dans lequel ladite poudre d'alliage de bronze d'aluminium comprend approximativement 10,0 % d'Al et le reste de Cu.

9. Procédé selon la revendication 7 ou 8, dans lequel ladite poudre d'alliage de bronze d'aluminium est appliquée par un procédé de projection par plasma.

10. Procédé selon la revendication 7, 8 ou 9, dans lequel ladite poudre d'alliage de bronze d'aluminium est appliquée jusqu'à ce que ledit revêtement ait une épaisseur entre 0,0010 et 0,0040 pouces (25 et 100 microns).

11. Procédé selon l'une quelconque des revendications 7 à 10 dans lequel le disque de rotor (14) comprend un alliage de titane.
